# EUROPEAN PATENT SPECIFICATION

(11) **EP 0 434 045 B1**
(45) Date of publication and mention of the grant of the patent: **13.03.1996**
(21) Application number: 90124818.7
(22) Date of filing: 19.12.1990
(51) Int. Cl.: H01L 21/768, H01L 21/3105

(54) **Method of forming conductive material selectively**
Verfahren zum selektiven Herstellen von leitendem Stoff
Procédé de formation sélective de matériau conducteur

(30) Priority: 20.12.1989 JP 330402/89
(43) Date of publication of application: 26.06.1991
(73) Proprietor: FUJITSU LIMITED, Kawasaki-shi, Kanagawa 211 (JP)
(72) Inventor: Kosugi, Makoto, c/o Fujitsu Limited Patent Dept., Kawasaki-shi, Kanagawa 211 (JP)
(74) Representative: Sunderland, James Harry

(56) References cited:
- EP-A- 0 261 846
- EP-A- 0 391 562
- EP-A- 0 397 462
- IEDM, IEEE 1983, pages 550-53, T. Moriya et al." A planar metallization process-its application to tri-level Al interconnection.
- CVD for microelectronics, A. Sherman, Noyes Publications, N.J., USA, 1987.

## Description

The present invention relates to a method of selectively forming conductive material, and more particularly but not exclusively to a method of forming multilevel interconnections in semiconductor devices. More particularly, but not exclusively, the present invention relates to a method of forming a via plug, within a via hole, which electrically connects a lower layer wiring to an upper layer wiring in a multi level interconnect structure.

In recent years, requirements for higher speeds of operation in computer systems mean that further improvements in semiconductor integrated circuits, for example higher degrees of integration and higher speeds of operation, are required. As a result, not only the further microminiaturisation of semiconductor devices but also the microminiaturisation and the provision of multi-layered structures of wiring are considered to be more and more important.

For the realisation of multilevel interconnection structures, developments of techniques for planarising interlevel dielectric films and techniques for forming wirings in miniaturised fine holes, for connecting layers of a multilevel interconnection structure, are particularly important. Reliability of multilevel interconnections may be improved by further perfecting such techniques.

As methods for the planarisation of interlevel dielectric films in the formation of conventional multilevel interconnection structures, an organic resin coating method, an SOG (spin on glass) coating method, an etchback method and a bias sputtering method have been proposed. Among these methods, the method of planarisation by coating with organic resin is very simple in terms of process and is superior in the planarisation characteristic provided.

For connecting layers in a multilevel interconnection structure, plugs are formed by filling fine via holes formed on an interlevel dielectric film with conductive material. Usually, a selective CVD (chemical vapor deposition) method with tungsten (W), using tungsten hexafluoride (WF₆) as source gas and hydrogen (H₂) or silane (SiH₄) as reduction agent, has been used to form such plugs.

This method has been described, for example, in the IEEE IEDM Technical Digest (1987), CH2515-5/87, pages 9.4 IEDM 87-213 to 9.4 IEDM 87-216, by T. Ohba, S. Inoue and M. Maeda.

Tungsten (W) is well deposited on the bottom of a via hole, namely on an exposed conductor surface such as a metal surface, but W is difficult to deposit on inorganic dielectric film. It is thus said that deposition of W has "good selectivity". It is necessary for enhancing the reliability of multilevel interconnections to obtain such "good selectivity". For this purpose, PSG (phospho silicate glass) film or silicon dioxide (SiO₂) film formed by a thermal CVD method are excellent as the inorganic dielectric film. However, good selectivity cannot be obtained in relation to an SiO₂ film and a silicon nitride (Si₃N₄) film which have been formed by a sputtering method and a plasma CVD method.

It has been assumed that a desirable via plug for a via hole can be attained when selective CVD of tungsten W is performed on an SiO₂ film or on PSG formed by thermal CVD on an organic resin film coated for the purpose of planarisation. However, there remains a problem here that the SiO₂ film or PSG formed by thermal CVD on organic resin film is inferior in terms of adhesion to the organic resin film and has little mechanical strength, and thereby reliability of wiring is reduced as a result of peeling or generation of cracks in the course of manufacturing processes.

Recently, however, it has been disclosed in Japanese Laid-open Patent No. 77131/1988 (by Fukuyama, et al.) that a planar dielectric film ensuring good adhesion may be obtained by forming an inorganic dielectric film on the planarised resin film by an ion beam assisted deposition method.

However, it has been assumed, as can be understood from the above explanation, on the basis of the fact that CVD (W) having good selectivity cannot be obtained for SiO₂ film or Si₃N₄ film formed by a sputtering method or a plasma CVD method, that neither can CVD (W) having good selectivity be obtained for an SiO₂ film or an Si₃N₄ film formed by an ion beam assisted deposition method.

IEEE IEDM Technical Digest, CH 1973-7/83, pages 550-553, 1983, T. Moriya et al.: "A planar metallization process - its application to tri-level aluminium interconnection", discloses a process using selective CVD deposition of tungsten to refill a via hole or contact window etched by RIE in a SiO₂ film. This documents considers the selectivity of the CVD tungsten deposition when SiO₂ is formed in different ways, for example as a thermal oxide, as a CVD oxide, as sputtered SiO₂ or plasma SiO₂. It also considers selectivity when thermal oxide is subjected to sputter etching or ion implantation. Selectivity is found to be good for thermal oxide and CVD oxide (i.e. few nucleation sites for deposition of tungsten on the SiO₂) but to be poor (many nucleation sites) for sputtered SiO₂ and plasma SiO₂, and for thermal oxide which has been subjected to sputter etching or ion implantation. It is said, however, that appropriate chemical treatment prior to deposition can reduce the number of nucleation sites to a level comparable to thermal oxide.

"Chemical Vapour deposition for Microelectronics", A. Sherman, Noyes Publications, New Jersey, USA, 1987, Section 5.6 Refractory Metals and Silicides, discusses plasma enhanced chemical vapour deposition of tungsten and other materials.

According to the present invention there is provided a method of selectively forming conductive material in a device having a substrate, comprising:-
forming a first dielectric film layer on the substrate,
forming a second dielectric film layer as an upper layer on top of the first dielectric film layer by an ion beam assisted deposition method in which vapourised constituents of the second dielectric film, formed by evaporation, are supplied with an accelerated ion beam,
forming a via hole through the first dielectric film layer and the second dielectric film layer,
and then selectively depositing the conductive material in the via hole by a chemical vapour deposition (CVD) method, whereby the conductive material is hardly deposited on the second dielectric film.

An embodiment of the present invention can provide a deposition method having good selectivity for the formation of conductive material film.

An embodiment of the present invention can offer improved reliability in relation to a method of forming multilevel interconnection for a semiconductor large-scale integrated circuit.

An embodiment of the present invention according to claim 1 employs the following processes:-
a process for forming a first metal wiring on a semiconductor substrate;
a process for forming a dielectric film, such as an organic resin film, on the semiconductor substrate and planarising the dielectric film;
a process for forming an inorganic dielectric film such as silicon dioxide (SiO₂), as an upper or uppermost dielectric film on the dielectric film, by an ion beam assisted deposition method;
a process for forming via holes on the first metal wiring through said upper or uppermost dielectric film and said dielectric film;
a process for selectively filling connection metal (plug) for the first metal wiring in the via holes;
   and
a process for forming second metal wiring on the upper or uppermost dielectric film covering the via holes.

As the upper or uppermost layer of planarised dielectric film, dielectric film formed by an ion beam assisted deposition method is used. A dielectric film formed by such an ion beam assisted deposition method is superior not only in terms of adhesion to the base dielectric film but also in terms of mechanical strength, because of the higher packing density of the film.

Moreover, a dielectric film formed by an ion beam assisted deposition method is also superior in terms of selectivity for selectively filling the metal plug in a via hole by a CVD method.

As explained above, reliability of multilevel interconnection may be increased through combination of the techniques for the planarisation of interlevel dielectric film and the filling of a via hole with a metal plug providing good selectivity.

Reference is made, by way of example, to the accompanying drawings, in which:-
Fig. 1 is a schematic sectional view for assistance in explaining a structure which can be provided through an embodiment of the present invention;
Fig. 2 illustrates an ion beam assisted deposition apparatus which may be used to form an upper or uppermost dielectric film in an embodiment of the present invention;
Fig. 3 is a schematic diagram illustrating a film forming process provided by an ion beam assisted deposition method;
Figs. 4(a) to 4(f) are schematic sectional views illustrating steps in a method of forming a structure employing an embodiment of the present invention;

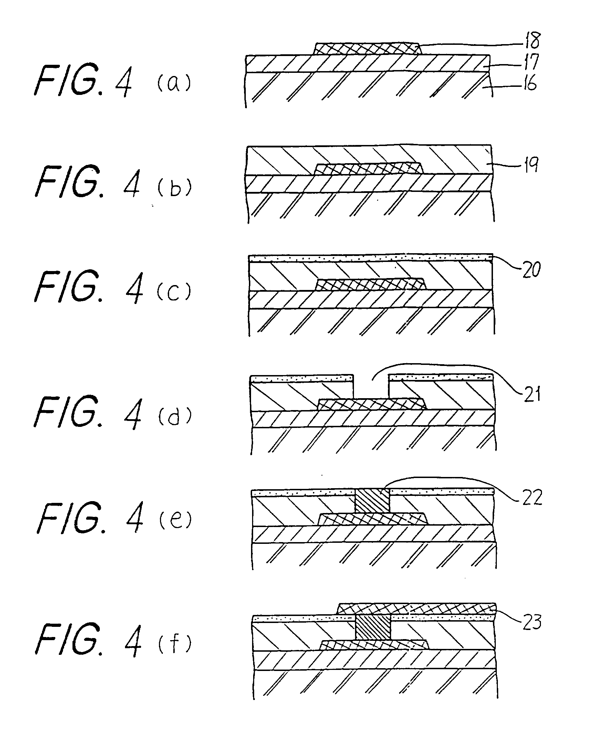

Fig. 4(a) shows a Ti/Au film formed as a first metal wiring;
Fig. 4(b) illustrates formation of a PMSS film and planarisation of the surface thereof;
Fig. 4(c) illustrates formation of an SiO₂ film on the PMSS film using an ion beam assisted deposition apparatus;
Fig. 4(d) illustrates formation of a via hole by simultaneously opening the SiO₂ film and PMSS film;
Fig. 4(e) illustrates selective deposition of a tungsten W film in the via hole by a CVD method; and
Fig. 4(f) illustrates formation of a second metal wiring film, a Ti/Au film, on the W film and SiO₂ film, by a sputtering method;

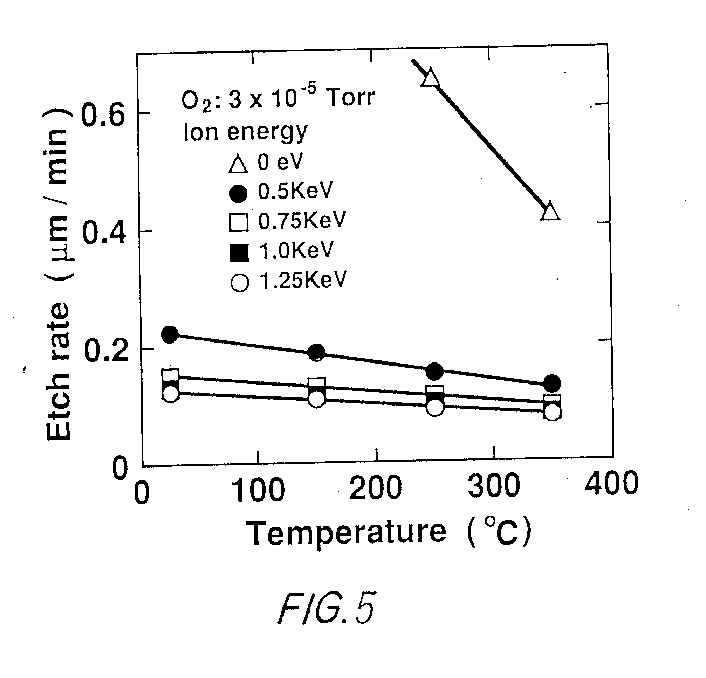

Fig. 5 is a diagram graphically indicating relationships between etch rate and substrate temperature in relation to SiO₂ films formed by an oxygen ion beam assisted method and etched by an aqueous solution of HF;
   and

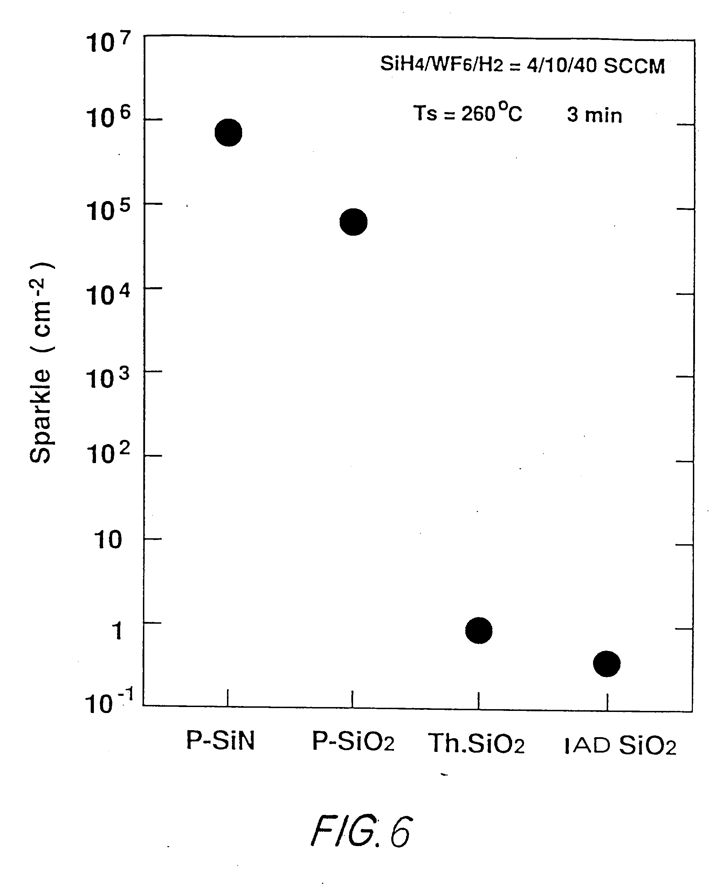

Fig. 6 is a diagram graphically comparing the densities of sparkle in cases in which tungsten W is deposited under similar conditions by a CVD method on four kinds of dielectric film.

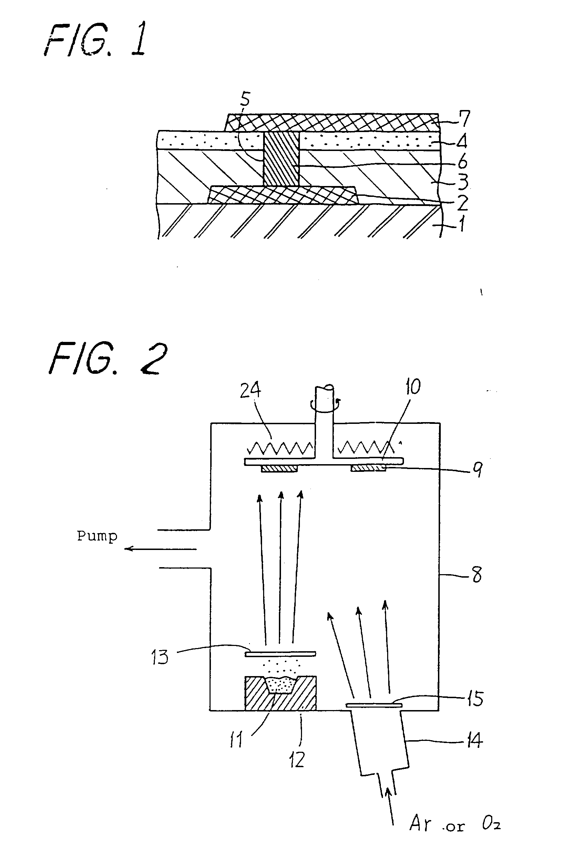

Fig. 1 is a schematic sectional view for assistance in explaining a structure which can be provided by an embodiment of the present invention. In this Figure, 1 is a semiconductor substrate; 2 is a first metal wiring; 3 is a dielectric film; 4 is an upper or uppermost dielectric film; 5 is a via hole; 6 is a metal plug for connection; 7 is a second metal wiring.

Such a structure may be obtained by means of the following processes according to an embodiment of the present invention. First metal wiring 2 is formed on semiconductor substrate 1, dielectric film 3 is formed on the semiconductor substrate 1, covering the metal wiring 2, and the surface is planarised and moreover upper or uppermost dielectric film 4 is formed on such dielectric film 3 by an ion beam assisted deposition method. Next, via hole 5 is formed on the first metal wiring 2 through the uppermost dielectric film 4 and the dielectric film 3. After metal plug 6 for connection is selectively filled in this via hole 5, second metal wiring 7 is formed on the upper or uppermost dielectric film 4.

Here, ion beam assisted deposition apparatus which can be used to form the upper or uppermost dielectric film 4 in an embodiment of the invention is schematically illustrated in Fig. 2. In this Figure, 8 is a vacuum chamber made of stainless steel; 9 is a substrate; 10 is a substrate holder; 24 is a substrate heater; 11 is an evaporation source; 12 is a crucible; 13 is an evaporation beam shutter; 14 is an ion source; 15 is an ion source shutter.

The vacuum chamber 8 is evacuated by a vacuum pump through an evacuation port and is kept at about 1 x 10⁻⁶ Torr. The evaporation source 11 is heated by an electron beam heater (not illustrated) and a vaporised source beam (an evaporation beam) reaches the surface of semiconductor substrate 9 for deposition. The evaporation beam quantity reaching the surface of the substrate 9 is controlled by an evaporation beam shutter 13. Meanwhile, an accelerated argon ion or oxygen ion beam is emitted from an ion source 14 and reaches the surface of semiconductor substrate 9 to enhance adhesion of deposited film to the substrate 9 and make dense the deposited film itself. The quantity of the ion beam is controlled by an ion source shutter 15 which operates in conjunction with the evaporation beam shutter 13. Since the substrate holder 10 for holding the semiconductor substrate 9 can be rotated around a centre axis thereof, a deposited film having good uniformity can be obtained.

In an example of the embodiment of the present invention, PMSS (silylated poly-methyl silsesquioxane), which is a kind of silicon resin, is used on the semiconductor substrate 1 as the dielectric film 3 provided for planarisation and an SiO₂ film is used as the upper or uppermost dielectric layer 4 formed by the ion beam assisted deposition method on the PMSS.

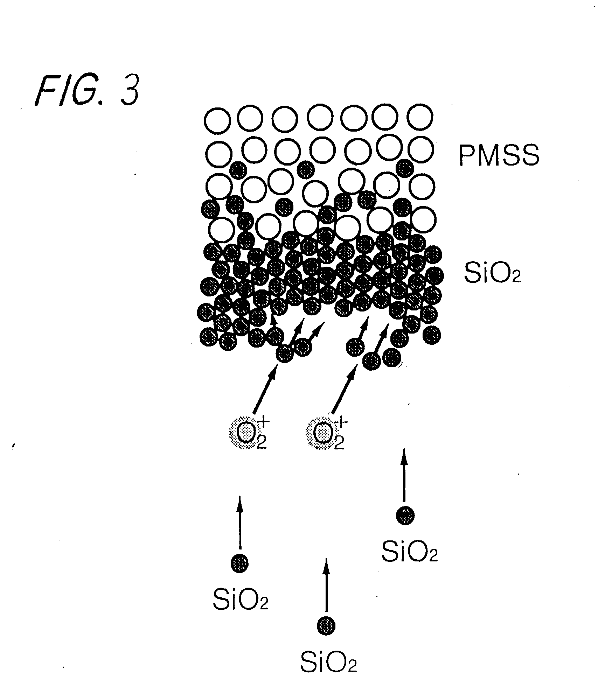

Fig. 3 schematically illustrates the film forming process when the SiO₂ film is formed on the PMSS film by the ion beam assisted deposition method. If the SiO₂ film were formed by the conventional evaporation method, the kinetic energy of SiO₂ molecules vaporised from the evaporation source would be about 0.2 eV. On the other hand, with the ion beam assisted deposition method, the SiO₂ molecules are given a kinetic energy of about 1.0 KeV, from the oxygen ions, for example, irradiated from the ion source. In this case, since the SiO₂ molecules deposited on the PMSS film have sufficient kinetic energy for migration on the surface, defective portions such as voids generated at the surface during formation of film can be filled with such SiO₂ molecules. Namely, dense film quality can be obtained and the surface, on the other hand, can always be kept in a flat condition. In addition, as shown in the same Figure, SiO₂ molecules partly having a large kinetic energy also enter the PMSS film. Thereby adhesion of SiO₂ film to PMSS film is increased in comparison with the result obtained with conventional evaporation. Moreover, it cannot be observed that nucleation sites are generated through coupling of dangling bonds existing in defective portions and metal atoms.

Next, a process of actual formation of a multilevel interconnection structure involving employment of an embodiment of the present invention will be explained with reference to Figs. 4(a) to 4(f).

As shown in Fig. 4(a), an SiO₂ film 17 is formed to a thickness of 1 µm on a silicon (Si) substrate 16 by a plasma CVD method. A titanium (Ti) film of a thickness of 10 nm and then a gold (Au) film of a thickness of 700 nm, for example, are sequentially formed on the SiO₂ by a sputtering method, and a Ti/Au film 18 is thus formed as a first metal wiring by patterning such films.

As shown in Fig. 4(b), a PMSS film 19 is coated to a thickness of e.g. 1.5 µm by a spin coating method. A flat surface can then be obtained by baking such PMSS film 19 through heating thereof for about an hour at about 350°C.

Next, as shown in Fig. 4(c), a SiO₂ film is formed to a thickness of about 200 nm on the PMSS film 19 using the ion beam assisted deposition apparatus shown in Fig. 2. In this case, the heating temperature of Si substrate 16 may range from room temperature to 400°C, the acceleration voltage of ions may be 1.25 kV for example and pressure of oxygen (O₂) or argon (Ar) gas may be 3 to 6 x 10⁻⁵ Torr for instance. Quartz powder (SiO₂) set in the crucible 12 as the evaporation source 11 is heated by an electron beam gun and the SiO₂ film 20 is formed on the PMSS film 19 by the vaporised SiO₂.

If a silicon nitride film is formed in place of the SiO₂ film 20, Si is used as the evaporation source 11 and nitrogen gas is supplied to the ion source 14.

Thereafter, as shown in Fig. 4(d), the SiO₂ film 20 and PMSS film 19 are simultaneously etched by a RIE (reactive ion etching) method using a resist mask, to form a via hole 21. In this case, a fluorine containing reactant gas such as tetrafluoromethane (CF₄), hexafluoroethane (C₂F₆) or trifluoromethane (CHF₃) may be used, under conditions such that pressure is set to 2 Torr, frequency is set to 13.56 MHz and applied power is 300 W.

Next, as shown in Fig. 4(e), a tungsten W film 22 is selectively deposited in the via hole 21 by a CVD method. In the case of this CVD method, a mixed gas of tungsten hexafluoride (WF₆), silane (SiH₄) and hydrogen (H₂) is used, substrate temperature is set in the range from 200°C to 400°C and more desirably from 250°C to 310°C . The flow rates of WF₆, SiH₄ and H₂ are respectively set to 10, 4 and 40 SCCM, but these flow rates are not subject to a need to meet severe requirements, namely, the flow rate of WF₆ may, for example, be in the range from 2 to 10 SCCM and that of SiH₄ in the range from 2 to 10 SCCM. Selectivity of tungsten for CVD is better as the substrate temperature is lower. Moreover, selectivity is further improved as the mixing ratio of reactant gas, namely SiH₄/(SiH₄ + WF₆) is smaller.

It is also possible to selectively deposit molybdenum (Mo) in place of tungsten in the contact hole 21. In this case, MoF₆ is used in place of WF₆.

Finally, as shown in Fig. 4(f), as for first metal wiring 18, a Ti film of a thickness of 10 nm and an Au film of a thickness of 700 nm are sequentially formed, by a sputtering method, on the SiO₂ film 20 covering the tungsten film 22, and then patterning is effected to form a second metal wring film 23.

In the structure of Figs. 4(a) to 4(f), Ti/Au is used as the first metal wiring film 18 and second metal wiring film 23, but it is also possible to use any of TiW/Au, Ti/Au/Pt, TiW/Au/TiW, TiW/Au/Mo, Aℓ, W, polysilicon, metal silicide film.

A two-level interconnect ion structure is formed as explained above, but a multilevel interconnect structure may, of course, be formed by repeating such processes.

Fig. 5 is a graph indicating densities of SiO₂ films 20 formed by methods as indicated in relation to Fig. 4(c). The vertical axis of this graph indicates an etching rate in a case in which the SiO₂ films are etched with hydrofluoric acid at room temperature, while the horizontal axis indicates a substrate temperature in a case in which the SiO₂ films are formed by oxygen ion beam assisted deposition method. In this graph, the relationship between the etching rate and substrate temperature is shown for the oxygen ion beam energies of 0, 0.5, 0.75, 1.0 and 1.25 KeV.

If the oxygen ion beam energy is 0 KeV, namely if there is no ion beam assist effect, etching rate for a substrate temperature of 300°C is about 0.5 µm/min. Meanwhile, when the oxygen ion beam energy is 0.75 KeV or more, etching rate for a substrate temperature 300°C is about 0.1 µm/min. and etching rate even for a substrate temperature as low as 100°C is about 0.2 µm/min. or less.

As explained above, SiO₂ films formed by the oxygen ion beam assisted deposition method exhibit increases of SiO₂ film density with the oxygen ion energy.

Fig. 6 is a graph useful for illustrating selectivities achieved with the CVD method of tungsten W deposition, as employed in Fig. 4(e) in accordance with an embodiment of the present invention. Fig. 6 shows results obtained when tungsten W film was deposited, by the CVD method, on SiO₂ films themselves formed by different methods; i.e. a plasma method, a thermal oxidisation method and an ion beam assisted deposition method (these SiO₂ films being designated p-SiO₂, Th-SiO₂, IAD-SiO₂) and an SiN film formed by a plasma method (designated p-SiN). The growth conditions for W in the CVD method were as follows. The flow rates of reactant gases SiH₄, WF₆ and H₂ were respectively 4, 10 and 40 SCCM, the substrate temperature was held at 260°C and growth time set to 3 min.

The black circles of Fig. 6 indicate density of sparkles (tungsten nuclei) formed on the dielectric films. With the CVD deposition as explained above, 10⁴ to 10⁶cm⁻ sparkles are formed on the p-SiN and p-SiO₂ respectively but as little as 1 cm⁻ sparkles are formed on the Th-SiO₂ and as little as or less than 0.3 cm⁻ sparkles are formed on the IAD-SiO₂.

From the fact that so few sparkles occur on the IAD-SiO₂, it is demonstrated that the SiO₂ film formed by the ion beam assisted deposition method has excellent selectivity for the selective CVD method of tungsten deposition.

Only a small amount of sparkles is formed on Th-SiO₂, but since a temperature as high as about 1000°C is required to form SiO₂ film by a thermal oxidation method, it is not a suitable method for use in processes to form wirings in manufacture of high density and large-scale integrated circuits.

Above, PMSS film is indicated to be used as the dielectric film 20, but it is also possible to further provide an inorganic dielectric film such as SiO₂ film, Si₃N₄ film and SiONₓ (silicon oxide nitride) film under the PMSS film or to apply an SOG film or a polyamide film in place of the PMSS resin.

Moreover, in a case in which the deposition surface is flat, the effect of the present invention may also be obtained even when the single layer of dielectric film formed by the ion beam assisted deposition method is employed, without need for a planarisation film such as a PMSS film.

Above, the description refers to an Si substrate but embodiments of the present invention can be employed also with compound semiconductor substrates.

Embodiments of the present invention can also be applied for the formation of the gate electrode wiring of a field effect transistor (FET) of compound semiconductor such as GaAs, AℓGaAs, for instance.

An embodiment of the present invention provides a method of forming a two-level interconnect structure by planarising a surface with a PMSS film covering Ti/Au wiring formed on a silicon substrate, forming thereon a SiO₂ film by an ion beam assisted deposition method, forming by an RIE method a via hole reaching the Au/Ti wiring simultaneously passing through the double layer (SiO₂ and PMSS) films, next forming a tungsten plug filling such via hole by selective CVD of tungsten, and forming Ti/Au wiring on the SiO₂ film covering this tungsten plug.

An embodiment of the present invention provides a method of selectively forming conductive material on a substrate, said method comprising the steps of:-
forming a second dielectric film including a first dielectric film at least on the uppermost layer formed by the beam assisted deposition method on said substrate;
selectively forming a via hole through said second dielectric film; and
selectively depositing a conductive material film in said via hole under the condition that said conductive film does not substantially grow on said first dielectric film.

This method may further comprise the steps of:-
forming a first conductive material wiring before forming said second dielectric film between said substrate and the second dielectric film; and
forming the second conductive material wiring on said first dielectric film covering said via conductive material film filled in said via hole.

The substrate may be selected from the group comprising semiconductor such as silicon or compound semiconductor, conductive material and insulator.

The second dielectric film may comprise said first dielectric film and a third dielectric film formed under said first dielectric film and said third dielectric film is selected from the group comprising PMSS (silylated polymethyl silsesquioxane) film, polyamide film and SOG film and is formed on the substrate.

The first dielectric film may be selected from the group comprising silicon dioxide and silicon nitride.

The via hole may be formed by the RIE (reactive ion etching) using fluorine containing reactant gas.

The conductive material film may be selected from the group comprising tungsten and molybdenum formed by a selective CVD (chemical vapour deposition) method.

The first and second conductive material wiring may be selected from the group comprising double-layered structure film of titanium (Ti)/gold (Au), titanium tungsten (TiW)/Au, triple-layered structure film of TiW/Au/TiW, TiW/Au/molybdenum (Mo), Ti/Au/platinum (Pt) and single layer of aluminium (Aℓ), tungsten W, polysilicon and metal silicide.

The PMSS film may be formed by annealing PMSS coated on the silicon substrate by the spin coating method in the thickness of about 1.5 µm for an hour at 350°C.

The silicon dioxide film of said first insulation film may be formed under the substrate temperature ranged from room temperature to 400°C and more desirably under the temperature ranged from 200 to 310°C using oxygen ion beam assisted deposition method, said oxygen ion being accelerated by a voltage of 1.25 KV.

The selective CVD of tungsten may be carried out using a mixed gas of tungsten hexafluoride (WF₆), silane (SiH₄) and hydrogen (H₂) as the reactant gas at a substrate temperature ranged from 200 to 400°C and more desirably from 250 to 310°C.

The titanium-gold may be formed by the sputtering method depositing a titanium film in the thickness of 10 nm followed by depositing a gold film in the thickness of 700 nm.

## Claims

1. A method of selectively forming conductive material in a device having a substrate (1; 16), comprising:-
forming a first planarized dielectric film layer (3; 19) on the substrate (1; 16),
forming a second dielectric film layer (4; 20) as an upper layer on top of the first dielectric film layer (3; 19) by an ion beam assisted deposition method in which vapourised constituents of the second dielectric film, formed by evaporation, are supplied with an accelerated ion beam,
forming a via hole (5; 21) through the first dielectric film layer (3; 19) and the second dielectric film layer (4; 20),
and then selectively depositing the conductive material (6; 22) in the via hole (5; 21) by a chemical vapour deposition (CVD) method, whereby the substantially no conductive material is deposited on the second dielectric film (4; 20).

2. A method as claimed in claim 1, said method further comprising forming a third dielectric film layer (17) on the substrate (1; 16) and under the first dielectric film layer (3; 19).

3. A method as claimed in claim 1 or 2, said method further comprising forming a first conductive material wiring (2; 18) between the first dielectric film layer (3; 19) and the substrate (1; 16) or the third dielectric film layer (17), whereby the first conductive material wiring (2; 18) is in contact with the conductive material (6; 22) filled in the via hole (5; 21), forming a second conductive material wiring (7; 23) on the second dielectric film (4; 20) and covering the conductive material (6; 22) filled in the via hole (5; 21).

4. A method as claimed in claim 2, or claim 3 when read as appended to claim 2, wherein the third dielectric film is of silicon dioxide, silicon nitride or silicon oxynitride.

5. A method as claimed in claim 1, 2 or 3, wherein the second dielectric film (4; 20) is of SiO₂ or of Si₃N₄.

6. A method as claimed in claim 1, 2 or 3, wherein the first dielectric film (3; 19) is of PMSS (silylated polymethyl silsesquioxane), polyamide or SOG (spin on glass).

7. A method as claimed in claim 6, wherein the first dielectric film (3; 19) is of PMSS (silylated polymethyl silsesquioxane) formed by a spin coating method to a thickness of about 1.5 µm and annealed for about an hour at about 350°C.

8. A method as claimed in claim 1, 2, or 3, wherein the via hole (5; 21) is formed by reactive ion etching, for example using a fluorine containing reactant gas.

9. A method as claimed in claim 1, 2 or 3, wherein the conductive material (6; 22) is tungsten or molybdenum deposited by a chemical vapour deposition (CVD) method.

10. A method as claimed in claim 9, wherein the chemical vapour deposition of tungsten is carried out using a mixed gas of tungsten hexafluoride (WF₆), silane (SiH₄) and hydrogen (H₂) as reactant gas, with the substrate (1; 16) at a temperature in the range 200°C to 400°C, preferably in the range 250°C to 310°C.

11. A method as claimed in claim 5, wherein the second dielectric film (4; 20) is formed by oxygen ion beam assisted deposition with the substrate (1; 16) at a temperature in the range room temperature (e.g. 20°C) to 400°C, preferably in the range 200°C to 310°C, the oxygen ions being accelerated by a voltage of 1.25KV.

12. A method as claimed in claim 3, wherein the first and second conductive material wiring is provided by double-layered films of titanium (Ti)/gold (Au) or titanium tungsten (TiW)/gold (Au), or by triple-layered films of titanium tungsten (TiW)/gold (Au)/titanium tungsten (TiW) or titanium tungsten (Ti)/gold (Au)/molybdenum (Mo) or titanium (Ti)/gold (Au)/platinum (Pt), or by films of aluminium (Aℓ), tungsten (W), polysilicon, or metal silicide.

13. A method as claimed in claim 12, wherein the first and second conductive material wiring (2, 17; 18, 23) is provided by double-layered films of titanium (Ti)/gold (Au) formed by a sputtering method whereby a titanium film of 10 nm thickness is first deposited, followed by the deposition of a gold film of 700 nm thickness.

14. A method as claimed in any preceding claim, wherein the substrate (1; 16) is of silicon or is of compound semiconductor, or is of a conductive material or of an insulator material.

## Patentansprüche

1. Verfahren zum selektiven Ausbilden von Leitermaterial in einer Vorrichtung mit einem Substrat (1; 16), umfassend:
das Ausbilden einer ersten planarisierten dielektrischen Filmschicht (3; 19) auf dem Substrat (1; 16);
das Ausbilden einer zweiten dielektrischen Filmschicht (4; 20) als obere Schicht auf der ersten dielektrischen Filmschicht (3; 13) mit einem Ionenstrahl-unterstützten Abscheidungsverfahren, bei dem verdampfte Bestandteile des zweiten dielektrischen Films, gewonnen durch Verdampfen, mit einem beschleunigten Ionenstrahl zugeführt werden;
das Ausbilden eines Durchgangslochs (5; 21) durch die erste dielektrische Filmschicht (3; 19) und die zweite dielektrische Filmschicht (4; 20); und dann
das selektive Abscheiden des Leitermaterials (6; 22) in dem Durchgangsloch (5; 21) durch chemische Dampfabscheidung (CVD-Verfahren), wobei im wesentlichen kein Leitermaterial auf dem zweiten dielektrischen Film (4; 20) abgeschieden wird.

2. Verfahren nach Anspruch 1, wobei das Verfahren weiterhin das Ausbilden einer dritten dielektrischen Filmschicht (17) auf dem Substrat (1; 16) und unter der ersten dielektrischen Filmschicht (3; 19) umfaßt.

3. Verfahren nach Anspruch 1 oder 2, wobei das Verfahren zudem das Ausbilden einer ersten Verdrahtung (2; 18) aus Leitermaterial umfaßt und zwar zwischen der ersten dielektrischen Filmschicht (3; 19) und dem Substrat (1; 16) bzw. der dritten dielektrischen Filmschicht (17), wobei die erste Verdrahtung (2; 18) aus Leitermaterial in Kontakt mit dem Leitermaterial (6; 22) ist, das in das Durchgangsloch (5; 21) gefüllt ist, und das Ausbilden einer zweiten Verdrahtung (7; 23) aus Leitermaterial auf dem zweiten dielektrischen Film (4; 20) und Abdecken des Leitermaterials (6; 22), das in das Durchgangsloch (5; 21) gefüllt ist.

4. Verfahren nach Anspruch 2 oder Anspruch 3, wenn abhängig von Anspruch 2, wobei der dritte dielektrische Film aus Siliciumdioxid, Siliciumnitrid oder Siliciumoxinitrid besteht.

5. Verfahren nach Anspruch 1, 2 oder 3, wobei der zweite dielektrische Film (4; 20) aus SiO₂ oder Si₃N₄ besteht.

6. Verfahren nach Anspruch 1, 2 oder 3, wobei der erste dielektrische Film (3; 19) aus PMSS (silyliertem Polymethyl-silsesquioxan), Polyamid oder SOG (Spin-Glas) besteht.

7. Verfahren nach Anspruch 6, wobei der erste dielektrische Film (3; 19) aus PMSS (silyliertem Poymethylsilsesquioxan) besteht und mit einem Spin-Beschichtungsverfahren in einer Dicke von ca. 1,5 µm, getempert für ca. 1 Stunde bei ca. 350°C, ausgebildet ist.

8. Verfahren nach Anspruch 1, 2 oder 3, wobei das Durchgangsloch (5; 21) durch Reaktiv-Ionenätzen ausgebildet wird, z. B. mit einem flourhaltigen glasförmigen Reaktanden.

9. Verfahren nach Anspruch 1, 2 oder 3, wobei das Leitermaterial (6; 22) Wolfram oder Molybdän ist, das mit einem CVD-Verfahren (chemische Dampfabscheidung) abgeschieden wurde.

10. Verfahren nach Anspruch 9, wobei die chemische Dampfabscheidung von Wolfram erfolgt mit einem Gasgemisch aus Wolframhexafluorid (WF₆), Silan (SiH₄) und Wasserstoff (H₂) als gasförmiger Reaktand, wobei das Substrat (1; 16) bei einer Temperatur ist von 200°C bis 400°C, vorzugsweise von 250°C bis 310°C.

11. Verfahren nach Anspruch 5, wobei der zweite dielektrische Film (4; 20) durch eine Sauerstoffionenstrahl-unterstützte Abscheidung ausgebildet wird, wobei das Substrat (1; 16) eine Temperatur hat von Raumtemperatur (z. B. 20°C) bis 400°C, vorzugsweise von 200°C bis 310°C und die Sauerstoffionen mit einer Spannung von 1,25 KV beschleunigt werden.

12. Verfahren nach Anspruch 3, wobei die erste und zweite Verdrahtung aus Leitermaterial bereitgestellt werden durch Zweischichtenfilme aus Titan (Ti)/Gold (Au) oder Titan-Wolfram (TiW)/Gold (Au) oder durch dreischichtige Filme aus Titan-Wolfram (TiW)/Gold (Au)/Titan-Wolfram (TiW) oder Titan-Wolfram (TiW)/Gold (Au)/Molybdän (Mo) oder Titan (Ti)/Gold (Au)/Platin (Pt) oder durch Filme aus Aluminium (Al), Wolfram (W), Polysilicium oder Metallsiliciden.

13. Verfahren nach Anspruch 12, wobei die erste und die zweite Verdrahtung (2, 17; 18, 23) aus Leitermaterial bereitgestellt werden durch zweischichtige Filme aus Titan (Ti)/Gold (Au), ausgebildet durch ein Sputterringverfahren, wobei zunächst ein 10nm dicker Titanfilm abgeschieden wird und dann ein 700 nm dicker Goldfilm.

14. Verfahren nach irgendeinem vorhergehenden Anspruch, wobei das Substrat (1; 16) aus Silicium ist oder aus einem Verbund-Halbleiter oder aus einem Leitermaterial oder aus einem Isoliermaterial.

## Revendications

1. Procédé de formation sélective d'un matériau conducteur dans un dispositif présentant un substrat (1 ; 16), consistant :
à former une première couche de film diélectrique rendu plan (3 ; 19) sur le substrat (1 ; 16),
à former une seconde couche de film diélectrique (4 ; 20) en tant que couche de dessus sur le haut de la première couche de film diélectrique (3 ; 19) par un procédé de déposition assistée par faisceau ionique dans lequel des constituants vaporisés du second film diélectrique, formés par vaporisation, sont fournis avec un faisceau ionique accéléré,
à former un trou traversant (5 ; 21) à travers la première couche de film diélectrique (3 ; 19) et la seconde couche de film diélectrique (4 ; 20),
et à déposer ensuite sélectivement le matériau conducteur (6 ; 22) dans le trou traversant (5 ; 21) par un procédé de déposition en phase gazeuse par procédé chimique (CVD), par lequel pratiquement pas de matériau conducteur n'est déposé sur le second film diélectrique (4 ; 20).

2. Procédé selon la revendication 1, ledit procédé consistant en outre à former une troisième couche de film diélectrique (17) sur le substrat (1 ; 16) et sous la première couche de film diélectrique (3 ; 19).

3. Procédé selon la revendication 1 ou 2, ledit procédé consistant en outre à former un premier câblage de matériau conducteur (2 ; 18), entre la première couche de film diélectrique (3 ; 19) et le substrat (1 ; 16) ou la troisième couche de film diélectrique (17), par lequel le premier câblage de matériau conducteur (2 ; 18) est en contact avec le matériau conducteur (6 ; 22) remplissant le trou traversant (5 ; 21), à former un second câblage de matériau conducteur (7 ; 23) sur le second film diélectrique (4 ; 20) et à couvrir le matériau conducteur (6 ; 22) remplissant le trou traversant (5 ; 21).

4. Procédé selon la revendication 2 ou la revendication 3 lorsqu'elle dépend de la revendication 2, dans lequel le troisième film diélectrique est constitué de dioxyde de silicium, de nitrure de silicium ou d'oxynitrure de silicium.

5. Procédé selon la revendication 1, 2 ou 3, dans lequel le second film diélectrique (4 ; 20) est constitué de SiO₂ ou de Si₃N₄.

6. Procédé selon la revendication 1, 2 ou 3, dans lequel le premier film diélectrique (3 ; 19) est constitué de PMSS (poly(méthylsilsesquioxane)silylé), de polyamide ou de SOG (déposition centrifuge sur verre).

7. Procédé selon la revendication 6, dans lequel le premier film électrique (3 ; 19) est constitué de PMSS (poly(méthylsilsesquioxane)silylé) formé par un procédé de déposition centrifuge sur une épaisseur d'environ 1,5 µm et recuit pendant environ 1 heure à environ à 350°C.

8. Procédé selon la revendication 1, 2 ou 3, dans lequel on forme le trou traversant (5 ; 21) par gravure ionique réactive, en utilisant par exemple un gaz réagissant contenant du fluor.

9. Procédé selon la revendication 1, 2 ou 3, dans lequel le matériau conducteur (6 ; 22) est du tungstène ou du molybdène déposé par un procédé de déposition en phase vapeur par procédé chimique (CVD).

10. Procédé selon la revendication 9, dans lequel on réalise la déposition en phase vapeur par procédé chimique du tungstène en utilisant un mélange gazeux d'hexafluorure de tungstène (WF₆), de silane (SiH₄) et d'hydrogène (H₂) en tant que gaz réagissant avec le substrat (1 ; 16) à une température dans l'intervalle de 200°C à 400°C, de préférence dans l'intervalle de 250°C à 310°C.

11. Procédé selon la revendication 5, dans lequel on forme le second film diélectrique (4 ; 20) par déposition assistée par faisceau ionique d'oxygène avec le substrat (1 ; 16) à une température dans l'intervalle allant de la température ambiante (par exemple 20°C) à 400°C, de préférence dans l'intervalle de 200°C à 310°C, les ions oxygène étant accélérés par une tension de 1,25 kV.

12. Procédé selon la revendication 3, dans lequel les premier et second câblages de matériaux conducteurs sont fournis par des films bicouches de titane (Ti)/or (Au) ou de titane-tungstène (TiW)/or (Au) ou par des films tricouches de titane-tungstène (TiW)/or (Au)/titane-tungstène (TiW) ou de titane-tungstène (TiW)/or (Au)/molybdène (Mo) ou de titane (Ti)/or (Au)/platine (Pt) ou par des films d'aluminium (Al), de tungstène (W), de polysilicium ou de siliciure métallique.

13. Procédé selon la revendication 12, dans lequel les premier et second câblages de matériaux conducteurs (2, 17 ; 18, 23) sont fournis par des films bicouches de titane (Ti)/or (Au) formés par un procédé de pulvérisation cathodique, par lequel un film de titane d'épaisseur de 10 nm est déposé dans un premier temps, suivi par la déposition d'un film d'or d'épaisseur 700 nm.

14. Procédé selon l'une quelconque des revendications précédentes, dans lequel le substrat (1 ; 16) est constitué de silicium ou d'un semiconducteur à jonction ou est constitué d'un matériau conducteur ou d'un matériau isolant.
